(19) Europäisches Patentamt / European Patent Office / Office européen des brevets

(11) **EP 4 618 419 A1**

(12) **EUROPEAN PATENT APPLICATION**

(43) Date of publication:
**17.09.2025 Bulletin 2025/38**

(21) Application number: **24163319.7**

(22) Date of filing: **13.03.2024**

(51) International Patent Classification (IPC):
*H03K 17/95* (2006.01)    *G01B 7/02* (2006.01)
*G01V 3/10* (2006.01)

(52) Cooperative Patent Classification (CPC):
**H03K 17/9537; G01B 7/023; G01V 3/10;**
**H03K 17/9502; H03K 17/952;** H03K 2217/94021;
H03K 2217/94026

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Optosys SA**
**1720 Corminboeuf (CH)**

(72) Inventor: **Genilloud, Laurent**
**1680 Romont (CH)**

(74) Representative: **AMMANN PATENTANWÄLTE AG**
**Schwarztorstrasse 31**
**3001 Bern (CH)**

(54) **METHOD FOR SETTING TEMPERATURE COMPENSATION FOR A PLURALITY OF PROXIMITY SENSORS OF THE SAME KIND**

(57)    The method for setting temperature compensation for a plurality of proximity sensors of the same kind (60), each including a memory, comprises the steps of:
S1) arranging the proximity sensors in a temperature control chamber (61);
S2) capturing the output signal of each proximity sensor at different temperatures;
S3) based on the output signal captured, determining for each proximity sensor an individual correction as a function of the temperature, the individual correction serves for determining a corrected output signal, which has a reduced drift with regard to temperature changes; and
S4) storing for each proximity sensor information on the individual correction determined in the memory (25).

Fig. 6

## Description

The present invention relates to a method for setting temperature compensation for a plurality of proximity sensors of the same kind.

The proximity sensors include components which may behave differently when the ambient temperature changes such that a proximity sensor produces a different output signal. A proximity sensor may e.g. include a coil for emitting a magnetic field for detecting the proximity of an external object. The output signal may depend on the coil resistance, which changes with temperature.

In order to compensate for such a temperature drift in the output signal, it is known to correct it, whereby correction is set identically for all proximity sensor when they are of the same kind. However, although the proximity sensors are made up of the same components and are manufactured in the same way, there can still be a considerable variation in the output signals as the temperature changes.

It is an aim of the present invention to provide for a method for setting temperature compensation for a plurality of proximity sensors of the same kind such that each produces an output signal with a reduced temperature drift.

This aim is achieved by a method as defined in claim 1.

In the following description and claims proximity sensors of the same kind are sensors, which have the same components and have preferably the same dimensions. In one embodiment the dimensions of the proximity sensors of the same kind are the same. In another embodiment the dimensions of the proximity sensors of the same kind are the same with the exception of their lengths, which may vary. Preferably, their manufacturing process, until they are subjected to the method according to the present invention, is the same for each of the proximity sensors of the same kind, such that they look identical except for possible markings such as a production number that may be used to identify an individual proximity sensor.

The provision of the steps of capturing the output signal at different temperatures and determining for each of the plurality of proximity sensors an individual correction as a function of the temperature makes it possible to set for each proximity sensor an individual correction so that variations originating e.g. from the manufacturing process can be encountered. The output signal can be corrected such that it shows a reduced drift with regard to temperature changes.

Each of the plurality of proximity sensors of the same kind may serve for detecting the proximity of an external object and may be configured as an inductive proximity sensor. Such an inductive proximity sensor may comprise a sensing part including a sensor coil for generating a magnetic field, the sensing part being arranged inside a front portion of a housing.

Each of the plurality of proximity sensors may be configured to determine at least one of

- the absence or presence of the external object within an operating distance of the proximity sensor, and
- the distance to the external object when located within the operating distance.

The further dependent claims specify preferred embodiments of the method.

In one embodiment of the method, the step of capturing the output signal at different temperatures output is performed in the absence of a target altering the magnetic field produced by a proximity sensor. This leads to a particularly simple procedure, as is not required to place specific targets at a specific distance in front of the sensors. For proximity sensors that are configured to detect a target based on the damping of a resonant circuit, the influence of the presence of a target may be taken into account based on separate measurements of at least one proximity sensor of the same kind, in which the damping resistance in the presence and in the absence of the target are determined.

The invention is explained in the following by means of exemplary embodiments with reference to Figures. In the drawings:

Fig. 1      shows an example of the proximity sensor in a schematic way;

Fig. 2      shows part of the resonant circuit of the sensor of Fig. 1;

Fig. 3      shows a transposed topology of the circuit of Fig. 2;

Fig. 4      shows an example of the damping resistance of a proximity sensor head as a function of the target distance;

Fig. 5      shows an example of the output signal of a proximity sensor as a function of the target distance;

Fig. 6      shows an embodiment of a chamber with sensors in a schematic way for performing the method according to the invention;

Fig. 7    shows an example of the temperature profile applied to the chamber of Fig. 6;

Fig. 8    shows examples of the output signal of several proximity sensors as a function of the temperature measured, wherein the same temperature compensation is applied to each sensor;

Fig. 9    shows the curves of Fig. 8 normalized with an offset; and

Fig. 10   shows the results for the sensors of Fig. 9, when temperature compensation is applied individually to each sensor.

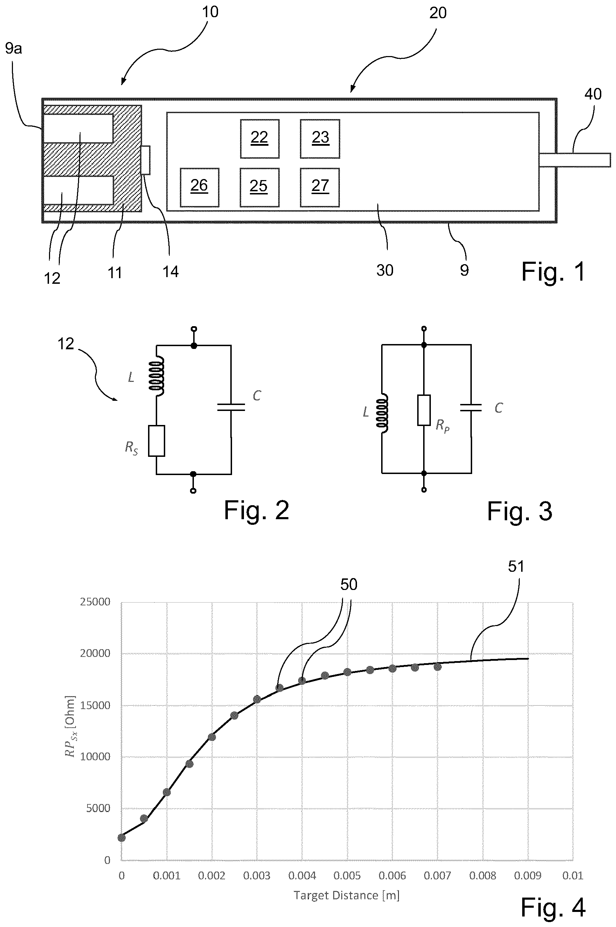

Fig. 1 shows an inductive proximity sensor including a sensing part 10 (in the following also denoted as "sensing head") and an evaluation part 20 arranged in a housing 9, which, at its front side, is closed by an end cap 9a.

The sensing part 10 includes a carrier 11, on which a sensing coil 12 is arranged, and a capacitor 14. The carrier 11 is e.g. made of ferrite or another material for shaping, in particular focusing the magnetic field emitted by the inductive proximity sensor. The sensing coil 12, which has also an electrical resistivity, and the capacitor 14 are configured to form a resonant circuit, in particular a LC-circuit. Thus, components 12, 14 form an oscillator.

The evaluation part 20 includes a circuitry with the following elements:

- 
- a signal shaping component 22 for receiving a signal from the resonant circuit and for shaping the signal to give a response that increases, preferably in a monotonical way, when the target distance increases;
- an output amplifier 23 which amplifies the signal received from the signal shaping component 22 in order to enable a digitalization of the signal;
- a temperature probe 26 for sensing a temperature T;
- a computing component 27 configured to receive signals from the output amplifier 24 and from the temperature probe 26, to digitalize those signals and to determine a corrected signal;
- a memory 25 for storing information used by the computing component 27.

The components 22, 23, 25-27 are arranged on a circuit board 30, in particular a printed circuit board. One or more of the components 22, 23, 25-27 may be part of an ASIC ("application-specific integrated circuit"). The computing component 27 and/or the memory 25 may be part of a microcontroller.

The proximity sensor includes a transfer part for transferring signals to an external device. The transfer part may be e.g. a cable 40 extending from the housing 9 as indicated in Fig. 1 and/or a connector arranged on the housing 9.

In the present example, the sensing coil 12 and the capacitor 14 with capacitance $C$ form a parallel resonant circuit, as schematically shown in Fig. 2. The sensing coil 12 is represented by a coil inductance $L$ and an ohmic resistance $R_s$.

In use, an alternating magnetic field is produced by the sensing coil 12 and the capacitor 14 and emitted through the front part 9a of the housing 9. The presence of an object (in the following also denoted by "target") can alter this field and the sensor is able to detect this alteration. The temperature probe 26 senses the temperature, which allows the determination of a correction signal as explained hereinafter.

The damping resistance of the proximity sensor may be experimentally determined using the sensing part 10 only. The resonant circuit of Fig. 2 can be transposed into a pure parallel topology as shown in Fig. 3, wherein the equivalent parallel resistance $R_P$ is purely ohmic and can be expressed by:

$$R_P = \frac{1}{R_S} \cdot \frac{L}{C} \qquad\qquad \text{(equation 1)}$$

The resistance $R_s$ of the coil 12 can be measured and the equivalent resistance $R_P$ can be determined by means of equation 1. The resistance $R_s$ and with it $R_P$ vary as the distance between the sensor and the target to be sensed varies.

Hereinafter, the following notations are used for a distance between the front end 9a of the sensor and a target to be sensed:

$S_{inf}$:    the target is set at infinity, in other words, there is no target, such as a metal target, in front of the sensor which would alter the magnetic field produced by the sensor;

$S_u$:    the target is set at a maximum upper distance, which is the maximum stated distance below which the output signal varies continuously;

(continued)

$S_l$: the target is set at minimum lower distance, which is the minimum stated distance above which the output signal varies continuously;

$S_x$: the target is set at a distance x between $[S_l, S_u]$

The relationship between the parallel resistance, $RP_{Sx}$, measured by the sensor head 10 when the target is set at a distance x, and the parallel resistance in the absence of a target, $RP_{Sinf}$, gives the damping factor $D_{Sx}$ at distance x:

$$D_{Sx} = 1 - \left( \frac{RP_{Sx}}{RP_{Sinf}} \right) \qquad \text{(equation 2)}$$

where $RP_{Sx}$ is the damping resistance when the target is set at a distance x and $RP_{Sinf}$ is the damping resistance when the target is set at infinity.

The sensor head damping resistance $RP_{Sx}$ can be measured e.g. with a Wayne Kerr Precision Component Analyzer.

Fig. 4 presents an example of the damping resistance measurement results for a M12 sensor head as dots 50. The target used here is made of steel of type FE 360, with a smooth surface and having a square shape with a thickness of 1 mm and a side length of 18 mm (in the following denoted as "standard target").

In Fig. 2 a curve 51 is fitted to the measured values 50 which is given by

$$RP_{Fit_x} = A_0 \cdot \frac{L + x^2 \cdot L_{coeff}}{R_S + x^2 \cdot R_{coeff}} \cdot \frac{1}{C} \qquad \text{(equation 3)}$$

where:

- $A_0$, $L_{coeff}$, $R_{coeff}$ are numerical coefficients determined by the fitting procedure
- $L$ is the sensor head inductance
- $x$ is the target distance
- $C$ is the sensor head capacitance
- $R_S$ is the resistance of the coil

The computing component 27, which may be part of. an ASIC, may be configured such that it provides an output signal $DISTRAW_{Sx}$ which is determined by means of the following formula

$$DISTRAW_{Sx} = \frac{G_3 \cdot \left( \frac{C_1}{\left( \frac{G_1}{G_2 \cdot RP_{Sx} + R_N} - \frac{(V_{ANAREF} + V_{RCUTCLP})}{R_{ANA}} - I_{ANAREFCST} \right)} - V_{Off1} \right) + V_{Off2}}{V_{REF}} \cdot 2^{14}$$

$$\text{(equation 4)}$$

In this equation 4, the only parameter correlated to the target distance is the damping resistance $RP_{Sx}$. In one example, the parameters are set e.g. as follows:

| Parameter | Value |
|---|---|
| $G_3$ | 1 |
| $C_1$ | 1 |
| $G_1$ | 20000 |
| $G_2$ | 0.02 |
| $R_N$ | 20000 |
| $V_{ANAREF}$ | 2000 |

(continued)

| Parameter | Value |
|---|---|
| $V_{RCUTCLP}$ | 2050 |
| $R_{ANA}$ | 80000 |
| $I_{ANAREFCST}$ | 0.45 |
| $V_{OFF1}$ | 2 |
| $V_{OFF2}$ | 0 |
| $V_{REF}$ | 0.1 |

The parameter $RP_{Sx}$ and in particular $RP_{Sinf}$ are limited, i.e. they do not exceed a specific value, e.g. 22 kOhm. Thus, $DISTRAW_{Sx}$ calculated by equation 4 will remain positive when $RP_{Sx}$ will become very large.

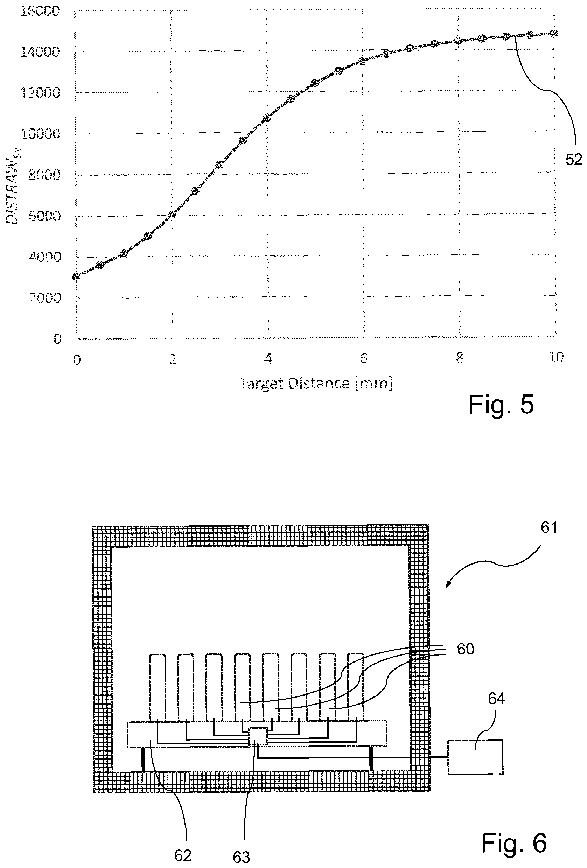

Fig. 5 shows a graphical representation of $DISTRAW_{Sx}$ versus the target distance for the values given in the table above. As can be seen from curve 52, the values for $DISTRAW_{Sx}$ are in the present example in the range of 0 to $2^{14}$ and thus can be represented by 14-bit digital number. Of course, the range may be defined differently. The output signal $DISTRAW_{Sx}$ tends to a constant value for an increasing target distance.

In equation 4

- the term $\dfrac{G_1}{G_2 \cdot RP_{Sx} + R_N}$ is dependent on the coil signal and thus dependent on the target distance,
- the term $V_{ANAREF}$ is used as an adjustment parameter obtained by means of a calibration of the sensor,
- the term $V_{RCUTCLP}$ is adjusted in relation to the temperature $T$ and is thus considered as a function of the temperature $T$.

Even if the sensors are of the same type and of the same dimensions, there is a dispersion between the coils of the different sensors. In addition, the sensor manufacturing process is not perfectly repeatable. These variations can be met by an individual adjustment for every sensor. This operation may be performed by optimizing $V_{ANAREF}$ value so that $DISTRAW_{Sx}$ is close to a specified value, when the sensor is exposed to a specific temperature, e.g. room temperature, which is typically in the range 23 ± 3 °C, and e.g. the standard target is set at distance $S_u$. The individual setting of the parameter $V_{ANAREF}$ may be done before the sensor is put into a climatic chamber 61, as explained below.

A variation of the ambient temperature induces a modification of the coil resistance value due to Joule heating law; this is the main reason for the sensor temperature drift. In other words, when the temperature is increasing, the losses in the coil resistor increase, leading to a sensor signal change. In order to compensate for these changes, one can vary $V_{RCUTCLP}$ in the equation 4 in dependence of the actual temperature. Thus, $V_{RCUTCLP}$ may be considered as a function of the temperature, $V_{RCUTCLP}(T)$.

Having a multiple of sensors of the same kind, i.e. they have the same components and preferably the same dimensions, information on $V_{RCUTCLP}(T)$ may be determined for each sensor individually, as explained hereafter.

In a first step, initial data on $V_{RCUTCLP}(T)$ e.g. in form of an initial look-up table may be determined by the following procedure:

At least one sensor, which is of the same kind, is monitored to determine the $V_{RCUTCLP}(T)$ function. The measurements are performed varying the temperature. To this end, the following procedural steps are performed:

1. place a sensor in a climatic chamber,
2. set a desired value for the temperature in the climatic chamber,
3. allow the climatic chamber and the sensor to reach a temperature equilibrium,

A. place e.g. the standard target at distance at upper distance ($S_u$) in front of the sensor,
B. measure the output signal of the sensor, which would correspond to $DISTRAW_{Su}$,
C. determine the correction $V_{RCUTCLP}$ to apply, so that $DISTRAW_{Su}$ remains constant.

Steps A to C may be repeated for different temperatures, e.g. -25°C, 0°C, 25°C, 50°C, 70°C. Steps 1 to 3 may be repeated for a multiple of sensors and the values obtained for $V_{RCUTCLP}$ may be averaged.

Depending on the purpose of the application, this procedure can also be simplified or set up differently. As explained below, the function $V_{RCUTCLP}(T)$ is set individually for each sensor so that approximate values are also sufficient as initial data for $V_{RCUTCLP}(T)$.

In order to reduce the computation complexity in the sensor, the function $V_{RCUTCLP}(T)$ may be approximated using a temperature Look-Up-Table (LUT). The LUT may be represented e.g. as an array with 12x2 components. In one example, the following values are given:

| LUT input in °C | LUT Output |
| --- | --- |
| -50 | 3256 |
| -34 | 2822 |
| -18 | 2419 |
| -2 | 2046 |
| 14 | 1705 |
| 30 | 1395 |
| 46 | 1116 |
| 62 | 868 |
| 78 | 651 |
| 94 | 465 |
| 110 | 310 |
| 126 | 186 |

Application of the temperature LUT makes use of

- an input in form of the temperature measured by the temperature probe 26 of the sensor,
- and an output for $V_{RCUTCLP}$ which may be determined e.g. by an interpolation of the values stored.

The process of an individual temperature compensation includes

- measuring the relationship between the sensor temperature and the sensor output response when the ambient temperature is varied between [$T_{min}$, $T_{max}$], and
- determine the LUT for every measured sensor.

It has been surprisingly found that for the measurements is not necessarily required that a target which would alter the magnetic field is positioned in front of a sensor 60. Thus, the output signal for the distance $S_{inf}$ can be measured.

In order to determine the temperature compensation for the distance $S_u$, i.e. for the case in which e.g. the standard target is present at the upper distance $S_u$, at least one sensor of the same kind is beforehand examined (called hereafter as *golden sample*) in order to determine the damping factor as explained above in relation to equation 2. To this end, for a sensor of the golden sample

- the damping resistance $RP_{Sinf}$ (meaning that no target is present) is measured,
- the damping resistance $RP_{Su}$ (meaning that e.g. the standard target is at distance $S_u$) is measured,
- and the factor $F = RP_{Su} / RP_{Sinf}$ is determined.

The measurements for the golden sample may be done at a specific temperature, e.g. at room temperature, which is typically in the range 23 ± 3 °C. The golden sample may include one or more sensors. In case that the golden sample includes several sensors, an average of the factors F determined may be used e.g. for the further procedure.

To provide for an individual temperature compensation, a multiple of sensors 60, which are of the same kind and of the kind of the golden sample, are placed in a temperature control chamber in form of a climatic chamber 61 as schematically shown in Fig. 6. The climatic chamber 61 allows controlling the temperature inside the chamber 61 and thus enables an exposure of the sensors 60 to different temperatures in a range [$T_{min}$, $T_{max}$]. A carrier equipment 62 is provided on which the sensors 60 are positioned. Further, the sensors 60 can be connected electrically to the carrier equipment 62 so that the signals provided by the sensors 60 can be read out. A suitable communication connection to a computer system 64 is provided, so that it can collect data from the sensors 60 and send data to the sensors 60, e.g. data to be stored in a memory 25 of a sensor 60. The communication connection includes e.g. an IO-Link master 63, to which the sensors 60 are connected and from which a communication with the computer system 64 possible, for instance via Ethernet.

The carrier equipment 62 is configured such that it can receive a least ten sensors 60, preferably at least twenty sensors 60 and most preferably at least fifty sensors 60, e.g. 64 sensors 60.

Further, a control equipment and a dedicated software application are provided enabling to record from every sensor 60:

- the temperature T measured by a temperature probe 26,
- the output signal provided by a sensor 60 corresponding to $DISTRAW_{Sinf}$,
- the initial LUT stored, which may be the same for each sensor 60 as they are of the same kind,
- parameters of the ASIC if provided, which are not necessarily the same for each sensor 60, even if they are of the same kind, e.g. the parameter $V_{ANAREF}$ may differ.

In the measurement process, the following steps are performed for each sensor 60 at different temperatures:

- the output signal provided by the sensor 60 corresponding to $DISTRAW_{Sinf}$ is measured
- based on the measured value for $DISTRAW_{Sinf}$ and on equation 4 the corresponding value for $RP_{Sinf}$ is determined,
- using the factor F from the golden sample, the value $RP_{Su}$ is determined,
- based on the determined value for $RP_{Su}$ and equation 4 the value $DISTRAW_{Su}$, is calculated.

Ideally, the output of the sensor should not change when the temperature changes. LUT values for the parameter $V_{RCUTCLP}$ are determined such that the variations of $DISTRAW_{Su}$, at different temperatures within the range [$T_{min}$, $T_{max}$] are reduced, preferably minimized. Finally, the LUT values are stored in a sensor 60.

As the measured values for $SISTRAW_{Su}$ are normally different for each sensor 60, the LUT values are also different for each sensor 60. Thus, individual LUT values are stored in each sensor 60, e.g. in its memory 25.

For the measurement process, it has been surprisingly found that it is not absolutely necessary that, after a change of temperature in the climatic chamber 61, a sensor 60 reaches temperature equilibrium. This is less preferred as it makes the process more time consuming. It has been found that reliable measurements results can be obtained in that temperature equilibrium may be e.g. achieved at $T_{min}$ and/or $T_{max}$ only or in that no temperature equilibrium is achieved, whereas the temperature in the climatic chamber 61 is gradually changed and the output of a sensor 60 is measured recurrently. In one example the wanted value of the temperature in the climatic chamber 61 is varied from a minimal temperature to a maximum temperature in a linear way, e.g. the temperature slope is 0.5°C/min, and the sensor output is measured at regular intervals, e.g. every minute.

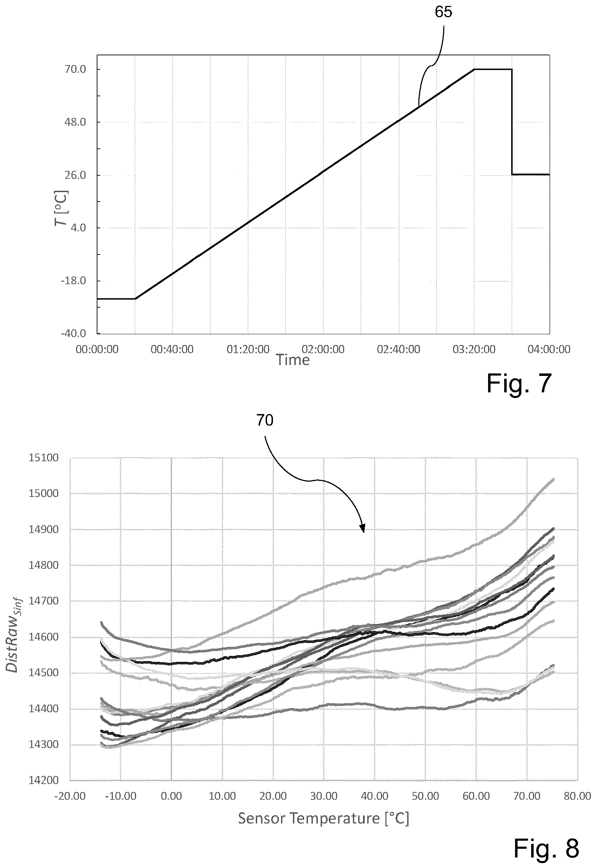

Fig. 7 shows an example of the temperature profile 65, wherein the abscissa represents time in units of hh:mm:ss (hour, minute, and seconds), and the ordinate corresponds to the setpoint temperature T in the climatic chamber 61. In this example, measurement takes 4 hours. In the beginning at $T_{min}$, the temperature is kept constant, e.g. for 20 minutes, and afterwards the temperature is increased linearly from -25 °C to 70 °C. At $T_{max}$ the temperature is kept constant, e.g. for 20 minutes, and is changed finally to an intermediate temperature, e.g. -26 °C, where it is again kept constant, e.g. for 20 minutes. Depending on the application, a different temperature profile is of course possible.

In order to validate the temperature compensation individually set, one may measure the relationship between the sensor temperature and the sensor output response when the ambient temperature is varied between [$T_{min}$, $T_{max}$].

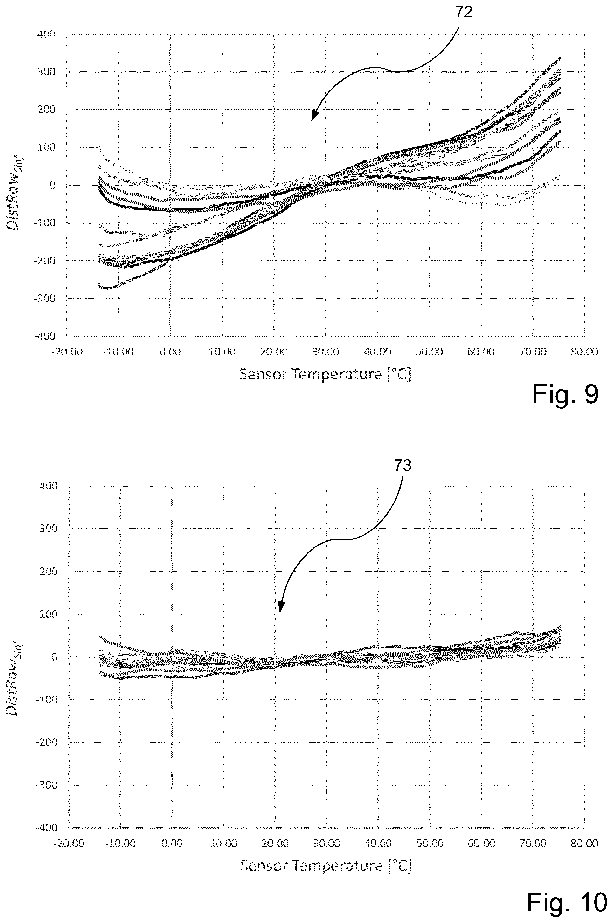

In the following Fig. 8 to 10, the abscissa in each diagram is the temperature as measured by the temperature probe 26 of a sensor in degree Celsius, and the ordinate corresponds to the output value of a sensor in the absence of a target, $DISTRAW_{Sinf}$, in arbitrary values. In Fig. 9 and 10, the values of $DISTRAW_{Sinf}$ are normalized as explained below. Fig. 8 to 10 show each the values for 14 different proximity sensors when the ambient temperature is varied from -15°C to 75°C, wherein all sensors are of the same kind.

The curves 70 in Fig. 8 show the behaviour of the sensors, when all have the same initial temperature compensation LUT. In order to visualize the behaviour better, an offset may be subtracted from a curve 70 given by its average value. This leads to the curves 72 as shown in Fig. 9. By applying such an offset as described, each curve 72 has an average value of 0.

As can be seen, the values for $DISTRAW_{Sinf}$ vary in the range of about 600 units. Taking into account that in the present example the entire output value span is 10'000 units, one can determine that the relative maximum temperature drift is:

$$Temperature_{Drift} = \frac{600}{10000} = 6\% = \pm 3\%$$

The curves 73 in Fig. 10 show the behaviour of the proximity sensors, once they have stored the temperature compensation LUT individually determined. Again, the values of $DISTRAW_{Sinf}$ are normalized by subtracting an offset given by the average value of the original curve.

As can be seen, the values for $DISTRAW_{Sinf}$ vary in the range of about 100 units. The relative maximum temperature drift it thus

$$Temperature_{Drift} = \frac{100}{10000} = 1\% = \pm 0.5\%$$

Thus, a considerable improvement in temperature compensation can be achieved by setting temperature correction to each sensor individually.

From the preceding description, many modifications are available to the skilled person without departing from the scope of the invention, which is defined in the claims.

The temperature correction measures described herein to correct the output signal can be applied to various types of proximity sensors, which may be e.g. proximity inductive sensors and/or which are configured as switches or as sensors for determining the distance to an object when located within the operating distance of the proximity sensor.

**Claims**

1. A method for setting temperature compensation for a plurality of proximity sensors of the same kind (60), each including a memory (25), the method comprising the steps of:

   S1) arranging the plurality of proximity sensors in a temperature control chamber (61);
   S2) capturing the output signal of each of the plurality of proximity sensors at different temperatures;
   S3) based on the output signal captured, determining for each of the plurality of proximity sensors an individual correction as a function of the temperature, the individual correction serves for determining a corrected output signal, which has a reduced drift with regard to temperature changes; and
   S4) storing for each of the plurality of proximity sensors information on the individual correction determined in the memory (25).

2. The method according to claim 1, wherein in step S1 the output signal is captured for each of the plurality of proximity sensors (60) in the absence of a target altering the magnetic field produced by a proximity sensor.

3. The method according to claim 2, wherein in step S3 for determining the individual correction the influence of the presence of a target is taken into account by adjusting the output signal captured based on separate measurements of at least one proximity sensor of the same kind, in which measurements the output signal is captured in the presence of a target.

4. The method according to claim 3, wherein the separate measurements are made under at least one of the following conditions:

   • outside the temperature control chamber (61);
   • at a specific temperature;
   • at a specific temperature, which is in range 20 degrees Celsius to 25 degrees Celsius.

5. The method according to any one of the preceding claims, which includes at least one of the following features A1 to A4:

   A1) each of the plurality of proximity sensors (60) measures the actual temperature by means of a temperature probe (26) in the proximity sensor;
   A2) each of the plurality of proximity sensors (60) measures the actual temperature by means of a temperature probe (26) in the proximity sensor, the temperature probe being part of an ASIC;
   A3) in step S2 the output signals of the plurality of proximity sensors together with the temperature are captured recurrently;
   A4) in step S2 the output signals of the plurality of proximity sensors together with the temperature are captured at regular time intervals.

6. The method according to any one of the preceding claims, wherein each of the plurality of proximity sensors (60) includes a resonant circuit and is configured to detect a target based on the damping of the resonant circuit, wherein in step S3 for determining the individual correction the influence of the presence of a target is taken into account based on separate measurements of at least one proximity sensor of the same kind, in which the damping resistance in the presence and in the absence of the target is determined at least at one specific temperature.

7. The method according to any one of the preceding claims, wherein each of the plurality of proximity sensors (60) comprises a computing component (27) for determining the corrected output signal based on the information stored in step S4.

8. The method according to claim 7, wherein the computing component (27) includes at least one of the following features B1) to B6):

   B1) the computing component is configured to determine the corrected output signal based on a function which includes the target distance as a variable and a correction parameter, the correction parameter being set as the individual correction determined in step S3;
   B2) the computing component is configured to determine the corrected output signal based on the information on the individual correction which is stored in a look-up table in step S4, wherein the look-up table includes different temperatures;
   B3) the computing component is part of a microcontroller;
   B4) the computing component is part of a microcontroller, which includes the memory (25);
   B5) the computing component is connected to a digitization part for receiving and digitizing a signal from a or the resonant circuit comprised by a proximity sensor;
   B6) the computing component is part of a or the ASIC.

9. The method according to any one of the preceding claims, wherein for exposing the plurality of proximity sensors (60) to different temperatures in step S2, the setpoint temperature in the temperature control chamber (61) satisfies at least one of the following conditions C1 to C5:

   C1) after an optional initial phase and before an optional end phase, the setpoint temperature is continuously changed from a minimal setpoint temperature to a maximum setpoint temperature or from a maximum setpoint temperature to a minimal setpoint temperature;
   C2) after the optional initial phase and before the optional end phase, the setpoint temperature is continuously changed in a linear way from a minimal setpoint temperature to a maximum setpoint temperature or from a maximum setpoint temperature to a minimal setpoint temperature;
   C3) the setpoint temperature is maintained at a constant level for a defined time interval in at least one of the initial and end phases, so that the plurality of proximity sensors reaches a thermal equilibrium;
   C4) the minimal setpoint temperature is below 0 degree Celsius and by order of increasing preference at most minus 5 degree Celsius, at most minus 10 degree Celsius or at most minus 15 degree Celsius;
   C5) the maximum setpoint temperature is above 20 degree Celsius and by order of increasing preference at least 30 degree Celsius, at least degree 50 Celsius or at least 70 degree Celsius.

10. The method according to any one of the preceding claims, wherein in step S1 the plurality of proximity sensors (60) is arranged on a carrier equipment (62) which includes at least one of the following features D1 to D3:

   D1) the carrier equipment (62) is configured to receive at least ten sensors and by order of increasing preference at least twenty sensors or at least fifty sensors;
   D2) the carrier equipment (62) includes a communication component (63) for communication with a computer system (64) arranged outside the climatic chamber (61), the proximity sensors being connected to the communication component;
   D3) the communication component (63) includes an IO-Link master 63.

11. The method according to any one of the preceding claims, wherein each of the plurality of proximity sensors (60) includes at least one of the following components E1 to E3:

   E1) a sensing coil (12) arranged in a head portion (10) of a proximity sensor and configured to produce a magnetic field;
   E2) a capacitor (14), which is at least one of being part of a or the resonant circuit and arranged in the head portion of a proximity sensor;

E3) a or the digitization part for receiving and digitizing a signal form the resonant circuit.

12. The method according to any one of the preceding claims, which includes, prior to step S1, a manufacturing process, in which the plurality of proximity sensors of the same kind (60) are produced in the same way, so that they include the same components and have the same dimensions.

Fig. 1

Fig. 2

Fig. 3

Fig. 4

Fig. 5

Fig. 6

Fig. 7

Fig. 8

Fig. 9

Fig. 10

**EP 4 618 419 A1**

Europäisches
Patentamt
European
Patent Office
Office européen
des brevets

# EUROPEAN SEARCH REPORT

**Application Number**

EP 24 16 3319

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/094404 A1 (HASEGAWA RYOTA [JP] ET AL) 28 March 2019 (2019-03-28) | 1,2,5-12 | INV.<br>H03K17/95<br>G01B7/02<br>G01V3/10 |
| A | * the whole document *<br>- - - - - | 3,4 | |
| A | CN 107 294 520 B (SHENZHEN CHEVEN TECH CO LTD) 24 November 2020 (2020-11-24)<br>* abstract *<br>- - - - - | 1-12 | |

TECHNICAL FIELDS
SEARCHED      (IPC)

H03K
G01B
G01V

The present search report has been drawn up for all claims

| Place of search | Date of completion of the search | Examiner |
|---|---|---|
| The Hague | 15 August 2024 | Loiseau, Ludovic |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

15

## ANNEX TO THE EUROPEAN SEARCH REPORT
## ON EUROPEAN PATENT APPLICATION NO.

EP 24 16 3319

This annex lists the patent family members relating to the patent documents cited in the above-mentioned European search report.
The members are as contained in the European Patent Office EDP file on
The European Patent Office is in no way liable for these particulars which are merely given for the purpose of information.

15-08-2024

| Patent document cited in search report | Publication date | Patent family member(s) | Publication date |
|---|---|---|---|
| US 2019094404 A1 | 28-03-2019 | CN 109560803 A | 02-04-2019 |
| | | DE 102018103239 A1 | 28-03-2019 |
| | | JP 6965658 B2 | 10-11-2021 |
| | | JP 2019062268 A | 18-04-2019 |
| | | KR 20190035455 A | 03-04-2019 |
| | | US 2019094404 A1 | 28-03-2019 |
| CN 107294520 B | 24-11-2020 | NONE | |

EPO FORM P0459

For more details about this annex : see Official Journal of the European Patent Office, No. 12/82